Europäisches Patentamt

European Patent Office

Office européen des brevets

(19)

(11) Veröffentlichungsnummer: **0 061 603**
**B1**

(12)

# EUROPÄISCHE PATENTSCHRIFT

(45) Veröffentlichungstag der Patentschrift:
**05.12.84**

(21) Anmeldenummer: **82101732.4**

(22) Anmeldetag: **05.03.82**

(51) Int. Cl.³: **G 01 R  25/00**, G 01 R  33/02,
H 02 P  5/34, H 02 P  5/40,
H 02 P  7/42

(54) **Verfahren und Vorrichtung zum Erfassen des Winkels zwischen dem Luftspaltflussvektor und dem Ständerstromvektor einer von einem Stromzwischenkreis-Umrichter gespeisten Asynchronmaschine.**

(30) Priorität: **28.03.81  DE 3112326**

(43) Veröffentlichungstag der Anmeldung:
**06.10.82 Patentblatt 82/40**

(45) Bekanntmachung des Hinweises auf die Patenterteilung:
**05.12.84 Patentblatt 84/49**

(84) Benannte Vertragsstaaten:
**AT CH GB IT LI NL SE**

(56) Entgegenhaltungen:
**DE - A - 2 919 852**
**US - A - 3 593 083**
**US - A - 4 001 660**

**SIEMENS-ZEITSCHRIFT, Band 45, Heft 10 1971
Eerlangen W. FLÖTER et al. "Die
TRANSVEKTOR-Regelung für den feldorientierten
Betrieb einer Asynchronmaschine" Seiten 761 bis 764**

(73) Patentinhaber: **BROWN, BOVERI & CIE
Aktiengesellschaft, Kallstadter Strasse 1,
D-6800 Mannheim 31 (DE)**

(72) Erfinder: **Lisner, Herbert, Dipl.-Ing.,
Georg-Ludwig-Krebs-Strasse 8, D-6700 Ludwigshafen
(DE)**
Erfinder: **Michalak, Peter, Stettiner Strasse 76,
D-6940 Weinheim (DE)**

(74) Vertreter: **Kempe, Wolfgang, Dr. et al, c/o BROWN,
BOVERI & CIE AG Kallstadter Strasse 1,
D-6800 Mannheim-Käfertal (DE)**

**Beschreibung**

Die Erfindung betrifft ein Verfahren zum Erfassen des Winkels zwischen dem Luftspaltflussvektor und dem Ständerstromvektor einer 3phasigen Asynchronmaschine, die von einem Umrichter mit Stromzwischenkreis gespeist wird, wobei die Ständerspannungen und die Ständerströme gemessen werden. Die Erfindung betrifft ferner eine Vorrichtung zur Durchführung des Verfahrens.

Aus der Siemens-Zeitschrift 45 (1971), Heft 10, Seiten 757 bis 760, ist eine Einrichtung zur Messung des Luftspaltflussvektors bekannt. Diese Einrichtung besteht aus zwei um 90° gegeneinander versetzten Hallsonden im Luftspalt und einem Vektoranalysator, der aus den Messwerten der Sonden den Winkel errechnet, den der Flussvektor mit einer ständerfesten Bezugslinie bildet.

Will man den Einbau von Sonden in den Luftspalt vermeiden, aber trotzdem den Winkel zwischen Flussvektor und Ständerstromvektor bestimmen, muss man das Problem durch eine Messung von Ständerstrom und Ständerspannung angehen, die ja ohne Eingriff in die Maschine messbar sind.

Es sind eine Reihe von Verfahren und Vorrichtungen zur Bestimmung der gegenseitigen Phasenverschiebung zweier periodischer Grössen — Spannungen und/oder Ströme — bekannt. Im vorliegenden Fall kommt aber erschwerend hinzu, dass die Spannungen und Ströme in den Zuleitungen der Asynchronmaschine gegenüber der Sinusform stark verzerrt sind. Die Spannungen sind durch die Kommutierungsvorgänge in dem die Maschinen speisenden Wechselrichter mit Störungen überlagert. Der Strom besteht aus Rechteckblöcken einer Länge von 120° el. Insbesondere diese letzte Eigenschaft macht eine Bestimmung des Phasenwinkels durch einfachen Vergleich der Nulldurchgänge der Strom- und Spannungskurven unmöglich.

Aus der DE-OS 2 919 852 ist eine Lastzustandsregelung für eine umrichtergespeiste Asynchronmaschine bekannt, bei der die Spannungen und Ströme in den Zuleitungen zu der Asynchronmaschine gemessen werden und bei der aus diesen Messwerten die Phasenverschiebung zwischen Strom und Spannung bzw. deren Sinus bzw. Kosinus errechnet wird. Es handelt sich dabei jedoch um eine komplizierte Schaltung mit Funktionsgeneratoren, Dividierern, Multiplizierern sowie Summierern.

Der vorliegenden Erfindung liegt die Aufgabe zugrunde, ein einfaches Verfahren anzugeben, mit dem der Winkel zwischen dem Flussvektor und dem Ständerstromvektor einer umrichtergespeisten Asynchronmaschine über einen weiten Frequenzbereich bestimmt werden kann, ohne dass An- oder Umbauten an der Maschine erforderlich sind.

Diese Aufgabe wird dadurch gelöst, dass die Stromblöcke des Ständerstromes in Rechteckwellen konstanter Amplitude umgeformt und auf 180° el. verlängert werden, dass aus den Ständerspannungen die Grundwellenanteile herausgefiltert werden, dass die Phase der Grundwellenanteile um 90° el. nacheilend gedreht wird, dass die phasengedrehten Grundwellenanteile in Rechteckwellen konstanter Amplitude umgeformt werden, dass wenigstens eine Rechteckwelle der Ströme mit der Rechteckwelle der auf die Stromphase folgenden Spannungsphase multipliziert wird und dass davon der Mittelwert gebildet wird.

Als Ständerspannungen werden gemäss einer ersten Variante die gegen den Mittelpunkt des die Asynchronmaschine speisenden Netzes gemessenen Phasenspannungen ausgewertet. Der Mittelpunkt kann bei Bedarf auch künstlich, z.B. mittels eines Widerstandsnetzwerkes, gebildet sein. Diese Variante hat den Vorteil, dass nur ein Minimalaufwand an Bauteilen zur praktischen Realisierung nötig ist.

Gemäss einer zweiten Variante werden als Ständerspannungen die verketteten Spannungen des speisenden Netzes ausgewertet, wobei die phasengedrehten Grundwellenanteile der mit der jeweiligen Stromphase gleichnamig verknüpften verketteten Spannungen voneinander subtrahiert werden, bevor daraus die Rechteckwellen geformt werden. Diese Variante hat den Vorteil, dass ein Mittelpunkt nicht nötig ist und dass die Spannungswerte um den Faktor $\frac{1}{2} \cdot \sqrt{3}$ höher sind.

Bei dem erfindungsgemässen Verfahren wird somit zunächst aus den gemessenen Werten von Strom und Spannung die Amplitudeninformation eliminiert und die Amplitude auf einen festen Wert normiert. Durch die Verlängerung der 120° el. langen Stromblöcke auf 180° el. wird ferner auf einfache Weise die Grundwelle bzw. deren Nulldurchgänge restauriert. Die dadurch erzeugte Phasenverschiebung der Grundwelle der Stromblöcke von 30° el. wird dadurch kompensiert, dass nicht die zu der jeweiligen Stromphase zugehörige, d.h. gleichnamige Spannungsphase, sondern die auf die Stromphase folgende Spannungsphase, die zudem noch um 90° el. nacheilend gedreht wird, zur Ermittlung der Phasenverschiebung herangezogen wird. Die aus einem Phasenstrom und einer Phasenspannung gebildeten Rechteckwellen werden miteinander multipliziert. Das Ausgangssignal des Multiplizierers enthält die ·Information über die Phasenverschiebung zwischen Strom und Spannung in der Zuleitung zu der Asynchronmaschine und die Information über den Winkel zwischen Flussvektor und dem Ständerstromvektor. Allerdings enthält das Ausgangssignal des Multiplizierers auch noch ein Rechtecksignal mit der Speisefrequenz in den Zuleitungen zur Asynchronmaschine; aus diesem Grund wird aus dem Ausgangssignal des Multiplizierers der arithmetische Mittelwert gebildet. Am Ausgang des Mittelwertbildners entsteht eine Spannung, die für eine Phasenverschiebung von $\varphi = 0$ beispielsweise den Wert + 1, für $\varphi = 90°$ den Wert 0 und für $\varphi = 180°$ den Wert — 1 hat.

Obwohl es zur Bestimmung des Winkels völlig ausreicht, nur eine Stromphase und eine Spannungsphase miteinander zu verknüpfen, lässt sich eine Verbesserung dadurch erreichen, dass alle drei Stromphasen und alle drei Spannungsphasen parallel miteinander verarbeitet werden, dass die Ausgangssignale der Multiplizierer summiert werden und dass aus dem Summensignal erst der Mittelwert gebildet wird. Dadurch erreicht man, dass der Rechteckanteil am Ausgang des Summierverstärkers eine Frequenz besitzt, die dem 6fachen der Frequenz in den Zuleitungen zur Asynchronmaschine entspricht. Solche höherfrequenten Frequenzanteile lassen sich jedoch schaltungsmässig einfacher ausfiltern.

Vorzugsweise wird zur Herausfilterung der Grundwellenanteile aus den Ständerspannungen und zur Drehung der Phase um 90° el. nacheilend ein einfaches RC-Glied verwendet. Ein solches RC-Glied wirkt jedoch nicht nur als Tiefpassfilter und als Phasendrehglied, sondern auch als Amplitudenkorrekturfilter. Die Ausgangsspannung der Umrichter wird bekanntlich so gesteuert, dass mit steigender Frequenz auch die Amplitude zunimmt. Bei steigender Frequenz sinkt jedoch der Wechselstromwiderstand des Kondensators im RC-Glied, so dass sich insgesamt gesehen bei allen Frequenzen am Eingang des Schaltungsteiles, welches die Grundwelle der Phasenspannung in eine entsprechende Rechteckwelle umformt, konstante Eingangsspannungsverhältnisse ergeben.

Wie oben erwähnt, enthalten die Ausgangssignale der Multiplizierer einen Wechselspannungsanteil, der proportional der Frequenz der Spannungen und Ströme in den Zuleitungen zur Asynchronmaschine ist. Da die Frequenzen von Spannung und Strom in den Zuleitungen zur Asynchronmaschine zwischen etwa 3 und etwa 150 Hz liegen können, müsste die Integrationskonstante des Mittelwertbildners an der unteren Frequenzgrenze sehr gross gewählt werden, um eine ausreichende Glättung des Mittelwertsignals zu bekommen. Diese grosse Integrationskonstante würde jedoch an der oberen Frequenzgrenze zu einer unerwünschten Verzögerung des Mittelwertsignals bei schnellen Änderungen der Phasenverschiebung sorgen. Aus diesem Grunde wird vorteilhafterweise der Mittelwert in einem Integrationsglied gebildet, dessen Integrationskonstante proportional zur Frequenz der Ständerspannungen bzw. Ständerströme variiert.

Der vorliegenden Erfindung liegt ferner die Aufgabe zugrunde, eine Schaltungsanordnung anzugeben, mit der das erfindungsgemässe Verfahren durchgeführt werden kann.

Diese Aufgabe wird dadurch gelöst, dass am Ausgang eines Stromwandlers ein Nullspannungs-Komparator mit Hysterese angeordnet ist, in dessen Eingangskreis ein Amplitudenbegrenzer liegt, dass zwischen dem Ausgang wenigstens eines Spannungswandlers und dem Mittelpunkt des Speisesystems der 3phasigen Asynchronmaschine ein Differenzverstärker angeordnet ist, dass der Ausgang des Differenzverstäkers über ein RC-Glied mit grosser Zeitkonstante an den Eingang eines Nullspannungs-Komparators ohne Hysterese geschaltet ist, dass die Ausgänge der beiden Komparatoren auf einen Multiplizierer geschaltet sind und dass der Ausgang des Multiplizierers auf einen Mittelwertbildner geschaltet ist.

Der Amplitudenbegrenzer im Eingangskreis des Nullspannungs-Komparators mit Hysterese sorgt dafür, dass der Komparator unabhängig von der momentan fliessenden Stromstärke immer eine nahezu gleich hohe Eingangsspannung als Schaltspannung angeboten erhält. Der Komparator hat somit bei allen Stromstärken ein praktisch gleichartiges Schaltverhalten. Dies ist wichtig, da die Hauptaufgabe des Nullspannungs-Komparators mit Hysterese darin besteht, die 120° el. langen Stromblöcke in 180° el. lange Rechteckwellen umzuwandeln. Die Phasenspannung am Ausgang des üblichen Spannungswandlers wird zwischen der Phasenleitung und dem Mittelpunkt des Speisesystems der Asynchronmaschine ermittelt. Sollte ein Mittelpunktleiter nicht vorgesehen sein, wie es normalerweise der Fall ist, so kann der Mittelpunkt künstlich mit Hilfe eines Widerstandsnetzwerkes erzeugt werden. Die Verwendung eines Differenzverstärkers, der vorzugsweise auf eine optimale Gleichtaktunterdrückung ausgelegt ist, in der Eingangsstufe ermöglicht eine gute Unterdrückung der den Phasenspannungen üblicherweise überlagerten gleichphasigen Störungen. Wirkungsweise und Vorteile des integrierenden RC-Gliedes mit grosser Zeitkonstante sind bereits oben beschrieben.

Vorzugsweise entspricht die Anzahl der die Ströme und Spannungen verknüpfenden Schaltkreise der Anzahl der Phasen der Asynchronmaschine. Die Ausgänge der Multiplizierer sind dann — wie schon oben erläutert — auf einen Summierer geschaltet, aus dessen Ausgangssignal dann der Mittelwert gebildet wird.

Vorzugsweise ist der Komparator mit Hysterese ein geschalteter Operationsverstärker.

Gemäss einer bevorzugten Ausbildung besteht der Amplitudenbegrenzer im Eingangskreis des Komparators mit Hysterese aus zwei antiparallelen Dioden. Eine derartige Schaltung ist sehr einfach und preiswert und erfüllt ihre Aufgabe ausgezeichnet.

Da bei einem Wechsel der Drehrichtung der Asynchronmaschine die Reihenfolge der Strom- und Spannungsphasen geändert wird, ist auch in der erfindungsgemässen Schaltungsanordnung eine Umschalteinrichtung vorzusehen, die in diesem Fall für die richtige Zuordnung der Ströme zu der auf die jeweilige Stromphase folgenden Spannung sorgt. Dieser Umschalter ist vorzugsweise vor das integrierende phasendrehende RC-Glied geschaltet.

Vorzugsweise können der Summierer am Ausgang der Multiplizierer und der Mittelwertbildner vereinigt werden, indem ein geschalteter Operationsverstärker verwendet wird, bei dem die Summierung der Signale am Eingang erfolgt und die Mittelwertbildung durch einen vom Ausgang auf den Eingang rückgekoppelten Kondensator erreicht wird.

Wie schon oben beschrieben, ist es wünschenswert, an der unteren Frequenzgrenze eine grosse Integrationskonstante und an der oberen Frequenzgrenze eine kleine Integrationskonstante für die Mittelwertbildung zu haben.

Zur Lösung dieser Aufgabe ist dem Summierer und dem Mittelwertbildner ein Multiplizierer nachgeschaltet, an dessen zweitem Eingang ein Signal anliegt, das proportional der Frequenz des die Asynchronmaschine speisenden Netzes ist, und dessen Ausgang über einen Widerstand auf den Eingang des Summierers und Mittelwertbildners zurückgeführt ist. Das Signal am zweiten Eingang des Multiplizierers ist ein Gleichspannungssignal, dessen Grösse der Speisefrequenz der Asynchronmaschine direkt porportional ist. Mit Hilfe dieser Schaltung ist es möglich, bei kleinen Frequenzen eine grosse und bei grossen Frequenzen eine kleine Integrationskonstante zu erzeugen. Der der Phasenverschiebung zwischen Strom und Spannung in den Zuleitungen der Asynchronmaschine entsprechende Wert kann jetzt am Ausgang des Multiplizierers abgegriffen werden.

Zur Pegelanpassung kann dem Ausgang des Multiplizierers ein zusätzlicher, als Pegelanpassungsglied geschalteter Operationsverstärker nachgeschaltet sein.

Weitere Ausgestaltungen der Erfindung sowie ihre Vorteile ergeben sich aus der nachfolgenden Beschreibung eines Ausführungsbeispiels anhand der Zeichnungen.

Es zeigen:

Fig. 1 ein Vektordiagramm der Spannungen und Ströme einer Asynchronmaschine im untersynchronen Betrieb,

Fig. 2 den Verlauf der Phasenspannung in den 3-phasigen Zuleitungen zu einer Asynchronmaschine sowie eine um 90° el. nacheilend phasenverschobene Phasenspannung,

Fig. 3 die Lage eines Phasenstromes bei einer Phasenverschiebung von 30° zwischen Spannungen und Strömen,

Fig. 4 den Spannungsverlauf am Ausgang des Multiplizierers bei einer Phasenverschiebung von 30°,

Fig. 5 die Lage eines Phasenstromes bei einer Phasenverschiebung von 150° zwischen Spannungen und Strömen,

Fig. 6 den Spannungsverlauf am Ausgang des Multiplizierers bei einer Phasenverschiebung von 150° und

Fig. 7 eine Schaltungsanordnung zur Ermittlung des Winkels bei einer 3phasigen Asynchronmaschine mit Mittelpunktleiter.

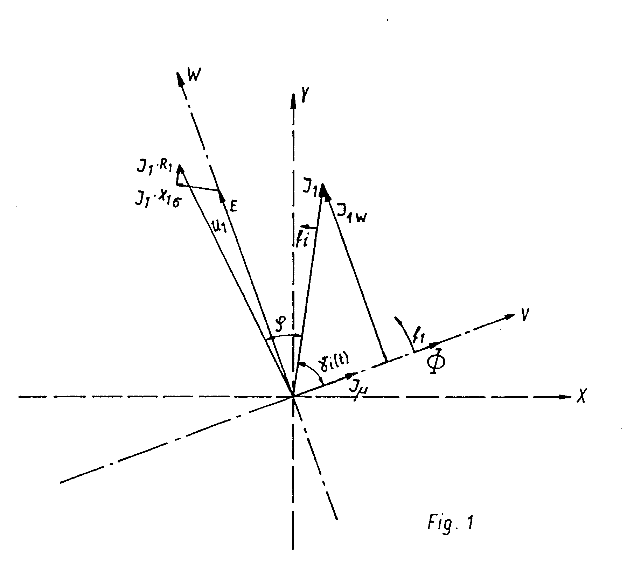

Das in Fig. 1 gezeigte Vektordiagramm ist eine Kombination aus Boedefeld/Sequenz «Elektrische Maschinen», 4. Auflage, 1949, Bild 235 mit ETZ-Archiv (1979) Heft 12, Seite 342, Bild 1. Man erkennt ein erstes rechtwinkliges Koordinatensystem mit den Koordinatenachsen X, Y, welches fest im Ständer der Maschine verankert sein soll. Man erkennt ein weiteres rechtwinkliges Koordinatensystem mit den Koordinatenachsen V, W, dessen Abszisse V mit dem Flussvektor zusammenfällt und das mit der Flussdrehfrequenz $f_1$ rotiert. Im rotierenden Koordinatensystem V, W sind die Strom- und Spannungsvektoren der Asynchronmaschine eingezeichnet. Man erkennt den Magnetisierungsstrom $I_\mu$, den Ständerstrom $I_1$ und den Ständerwirkstromanteil $I_{1w}$. Der Vektor des Magnetisierungsstroms $I_\mu$ bzw. der Vektor $\Phi$ des Luftspaltflusses und der Vektor $I_1$ des Ständerstroms schliessen einen Stromwinkel $\gamma_i(t)$ ein. Der Ständerstromvektor $I_1$ rotiert mit der Ständerstromdrehfrequenz $f_1$.

Senkrecht auf dem Vektor des Magnetisierungsstroms $I_\mu$ bzw. des Luftspaltflusses $\Phi$ steht der Vektor der elektromotorischen Kraft E. Zur elektromotorischen Kraft E addieren sich vektoriell die Spannungsabfälle im Ständerkreis. Die Summe entspricht genau der momentanen Ständerspannung $U_1$. Zwischen der Ständerspannung $U_1$ und dem Ständerstrom $I_1$ besteht die Phasenverschiebung $\varphi$.

Wie erwähnt, laufen der Flussvektor $\Phi$ mit der Drehfrequenz $f_1$, der Ständerstromvektor $I_1$ mit der Drehfrequenz $f_i$ gegenüber der Ständerwicklung um. Zwischen beiden befindet sich der Stromwinkel $\gamma_i(t)$ der sich mit der Schlupffrequenz ändert. Im stationären Betriebszustand sind die beiden Frequenzen $f_1$ und $f_i$ gleich. Bei dynamischen Vorgängen bleibt die Länge des Ständerstromvektors $I_1$ konstant, da die Stromamplitude vom Umrichter eingeprägt ist. Die Stromamplitude ändert sich erst nach Ablauf der dem Stromregelkreis immanenten Verzögerungszeit. Die Asynchronmaschine kann daher nur durch eine Änderung des Stromwinkels $\gamma_i(t)$ reagieren.

Da der Stromwinkel $\gamma_i(t)$ an den Klemmen der Asynchronmaschine nicht direkt gemessen werden kann und Sensoren für den Flussvektor $\Phi$ voraussetzungsgemäss nicht verwendet werden sollen, muss der Stromwinkel $\gamma_i(t)$ auf dem Umweg über die Phasenverschiebung zwischen Ständerstrom $I_1$ und Ständerspannung $U_1$ gemessen werden. Hierbei muss allerdings die Winkelabweichung zwischen dem Vektor der elektromotorischen Kraft E und dem Vektor der Ständerspannung $U_1$ vernachlässigt werden.

Es lässt sich zeigen, dass trotz dieser Vernachlässigung das Führungsverhalten eines Stromwinkelreglers besser ist als eines herkömmlichen Reglers, bei dem die dynamischen Änderungen des Stromwinkels $\gamma_i(t)$ vernachlässigt oder auf dem Umweg über die Höhe der Zwischenkreisspannung oder die Höhe der Rotordrehzahl errechnet werden.

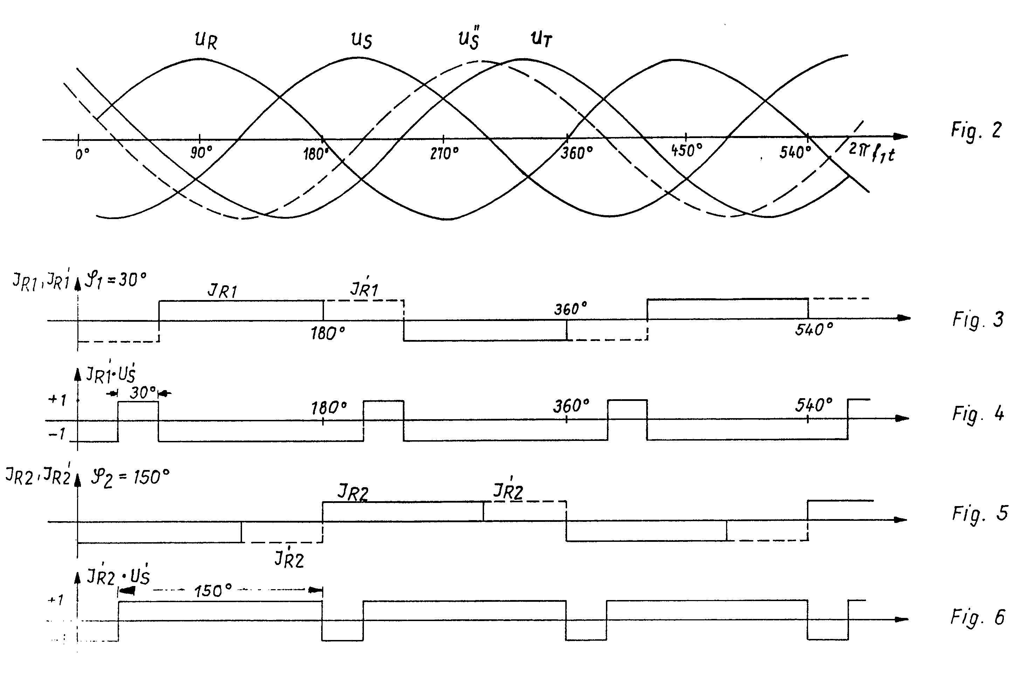

Fig. 2 zeigt den Verlauf der Ständerspannungen $U_R$, $U_S$, $U_T$ eines 3phasigen Speisenetzes, wobei nur die Grundwellenanteile gezeichnet sind. Die drei Spannungen sind jeweils 120° el. gegeneinander phasenverschoben. Eingezeichnet ist ferner der Verlauf der um 90° el. nacheilend phasenverschobenen Spannung $U_S''$.

Fig. 3 zeigt für eine Phasenverschiebung von $\varphi_1 = 30°$ die 120° el. langen Stromblöcke eines Ständerstromes $I_{R1}$ sowie die zugehörige, auf 180° el. verlängerte Rechteckwelle $I_{R1}'$.

Fig. 4 zeigt den Verlauf der Spannung am Ausgang eines Multiplizierers, in dem die Rechteckwellen entsprechend der Spannung $U_S'$ und des Stromes $I_{R1}'$ miteinander multipliziert sind. Man erkennt, dass die positiven Spannungsanteile genau 30° el. und die negativen Spannungsanteile 150° el. lang sind. Der arithmetische Mittelwert dieser Rechteckfolge hat eine Höhe von — 0,67.

Fig. 5 zeigt für eine Phasenverschiebung von $\varphi_2 = 150°$ den Phasenstrom $I_{R2}$ und die daraus gebildete und auf 180° el. verlängerte Rechteckwelle $I_{R2}'$.

Fig. 6 zeigt das Ergebnis am Ausgang des Multiplizierers. Man erkennt, dass hier die positiven Spannungsanteile 150° el., die negativen Spannungsanteile 30° el. lang sind und dass der arithmetische Mittelwert dieser Spannungswelle eine Grösse von + 0,67 besitzt.

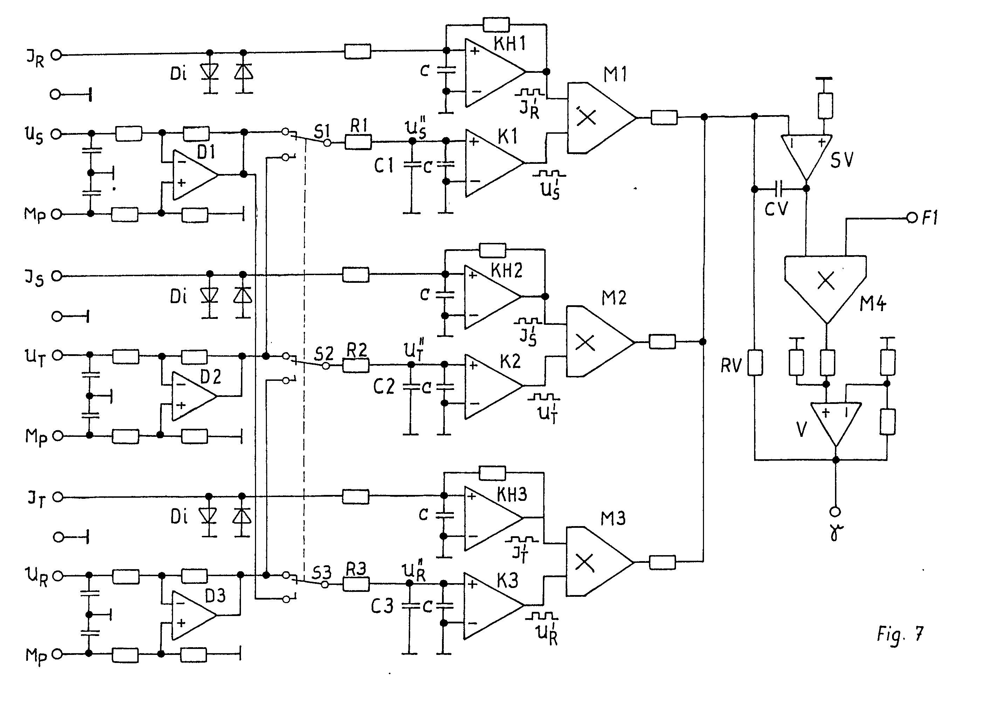

Fig. 7 zeigt eine Schaltungsanordnung für ein Vier-Leiter-Speisenetz. Verfolgt man zunächst das von einem (nicht dargestellten) Stromwandler kommende Signal für den Ständerstrom $I_R$, so erkennt man, dass dieses Signal zunächst mit Hilfe von zwei antiparallelen Dioden Di amplitudenbegrenzt und über einen Widerstand an den Eingang eines als Nullspannungs-Komparator HK1 mit der Hysterese geschalteten Operationsverstärkers gelangt. Der Kondensator C am Eingang dieses und aller weiteren Komparatoren dient dazu, kurzzeitige Störimpulse, die die die Amplitude begrenzenden Dioden Di passieren konnten, gegen Masse abzuleiten. Sobald am Eingang des Komparators KH1 eine positive Signalspannung anliegt, schaltet der Ausgang ebenfalls auf positives Signal. Dieses positive Ausgangssignal bleibt infolge der Hysterese auch dann noch erhalten, wenn das Eingangssignal in den Strompausen des Stroms $I_R$ zu Null wird. Erst wenn das Eingangssignal negativ wird, schaltet auch der Komparator KH1 am Ausgang auf negatives Signal. Auf diese Weise wird die Verlängerung der 120° el. langen Eingangssignalblöcke auf 180° lange Ausgangssignalblöcke realisiert.

Das von einem (nicht dargestellten) Spannungswandler kommende Spannungssignal $U_S$ zwischen dem Phasenleiter und dem Mittelpunktleiter Mp gelangt an einen auf optimale Gleichtaktunterdrückung beschalteten Differenzverstärker D1. Vom Ausgang des Differenzverstärkers D1 wird das Signal über einen Umschalter S1 an ein integrierendes RC-Glied R1, C1 mit grosser Zeitkonstante gelegt. Am Ausgang dieses RC-Gliedes steht die weitgehend von Oberwellen und Störungen gereinigte und um 90° el. nacheilend gedrehte Grundwelle $U_S''$ an. Aus diesem Spannungssignal $U_S''$ formt ein Komparator K1 ohne Hysterese eine Rechteckwelle $U_S'$.

Die Ausgänge der beiden Komparatoren KH1 und K1 sind auf die beiden Eingänge eines Multiplizierers M1 gelegt, der die beiden Rechteckwellen multipliziert und am Ausgang ein Signal abgibt, welches ausser der Wechselspannungskomponente mit der Frequenz von Strom $I_R$ und Spannung $U_S$ eine Amplitudeninformation enthält, die der Phasenverschiebung $\varphi$ zwischen Phasenspannung $U_S$ und Phasenstrom $I_R$ entspricht und gleichzeitig ein Mass für den Winkel zwischen Flussvektor und Ständerstromvektor ist.

Über zwei weitere, gleich aufgebaute Kanäle werden auch die Ströme $I_S$ und $I_T$ sowie die Spannungen $U_T$ und $U_R$ verknüpft. Mit Hilfe der gekoppelten Umschalter S1, S2, S3 ist es möglich, je nach Drehrichtung der Asynchronmaschine die auf die jeweilige Stromphase folgende Spannungsphase mit der Stromphase multiplikativ zu verknüpfen.

Die Ausgänge der drei Multiplikatoren M1, M2, M3 werden am Eingang eines als Summierer und Mittelwertbildner geschalteten Operationsverstärkers SV summiert. Der Operationsverstärker SV wirkt mit Hilfe des Kondensators CV gleichzeitig als Integrierer, so dass an seinem Ausgang der Mittelwert der Eingangsspannung ansteht.

Um die Integrationskonstante des Mittelwertbildners SV, CV frequenzabhängig steuern zu können, ist der Ausgang des Mittelwertbildners SV auf einen Multiplizierer M4 geschaltet, dessen zweitem Eingang eine Gleichspannung F1 zugeführt wird, die der Frequenz der Phasenspannung und Phasenströme direkt proportional ist. Der dem Multiplizierer M4 nachgeschaltete Operationsverstäker SV dient als Pegelanpassverstärker. Von seinem Ausgang ist ein Widerstand RV an den Eingang des Summierers und Mittelwertbildners SV geschaltet. Über diesen Widerstand RV wird abhängig von der Spannung F1 soviel Gegenkopplungssignal an den Eingang des Mittelwertbildners SV rückgekoppelt, dass bei kleinen Frequenzen und einer kleinen Spannung F1 eine grosse Zeitkonstante und bei grossen Speisefrequenzen und einer grossen Spannung F1 eine kleine Zeitkonstante sich einstellt.

Die nicht dargestellte Schaltungsanordnung für die zweite Variante, bei der die verketteten Spannungen des speisenden Netzes ausgewertet werden, unterscheidet sich von der in Fig. 7 dargestellten nur dadurch, dass die unteren Eingänge der Differenzverstärker D1, D2, D3 statt mit dem Mittelpunktleiter Mp mit einem Phasenleiter verbunden werden. Die Kombination der Spannungen und Ströme ist so zu wählen, dass $I_R$ mit $U_S$ und $U_R$, $I_S$ mit $U_T$ und $U_S$ sowie $I_T$ mit $U_R$ und $U_T$ verknüpft werden. Ausserdem müssen die unteren (Minus-)Eingänge der Komparatoren K1, K2, K3 ohne Hysterese statt mit Masse mit den oberen (Plus-)Eingängen des jeweils zyklisch vorangehenden Komparators verbunden werden, um durch die Differenzbildung zwischen den verketteten Spannungen den richtigen Phasenwinkel zu erhalten.

## Patentansprüche

1. Verfahren zum Erfassen des Winkels zwischen dem Luftspaltflussvektor und dem Ständerstromvektor einer 3phasigen Asynchronmaschine, die von einem Umrichter mit Stromzwischenkreis gespeist wird, wobei die Ständerspannungen und die Ständerströme gemessen werden, dadurch gekennzeichnet, dass die Stromblöcke der Ständerströme ($I_R$, $I_S$, $I_T$) in Rechteckwellen ($I_R'$, $I_S'$, $I_T'$) konstanter Amplitude umgeformt und auf 180° el. verlängert werden, dass aus den Ständerspannungen $U_R$, $U_S$, $U_T$ bzw. $U_{RS}$, $U_{ST}$, $U_{TR}$ die Grundwellenanteile herausgefiltert werden, dass die Phase der Grundwellenanteile um 90° el. nacheilend gedreht wird, dass die phasengedrehten Grundwellenanteile ($U_R''$, $U_S''$, $U_T''$ bzw. $U_{RS}''$, $U_{ST}''$, $U_{TR}''$) in Rechteckwellen $U_R'$, $U_S'$, $U_T'$ bzw. $U_{RS}'$, $U_{ST}'$, $U_{TR}'$) konstanter Amplitude umgeformt werden, dass wenigstens eine Rechteckwelle ($I_R'$) der Ströme mit der Rechteckwelle ($U_S'$, $U_T'$, bzw. $U_{RS}'$, $U_{TR}'$) der auf die Stromphase folgenden Spannungsphase multipliziert wird und dass davon der Mittelwert ($\gamma$) gebildet wird.

2. Verfahren nach Anspruch 1, dadurch gekennzeichnet, dass als Ständerspannung die gegen den Mittelpunkt (Mp) des die Asynchronmaschine (ASM) speisenden Netzes gemessenen Phasenspannungen ($U_R$, $U_S$, $U_T$) ausgewertet werden.

3. Verfahren nach Anspruch 1, dadurch gekennzeichnet, dass als Ständerspannung die verketteten Spannungen ($U_{RS}$, $U_{ST}$, $U_{TR}$) des die Asynchronmaschine (ASM) speisenden Netzes ausgewertet werden, dass die phasengedrehten Grundwellenanteile ($U_{RS}''$, $U_{TR}''$) der mit der jeweiligen Stromphase ($I_R$) gleichnamig verknüpften verketteten Spannungen ($U_{RS}$, $U_{TR}$) voneinander subtrahiert werden und dass die Spannungsdifferenz in eine Rechteckwelle ($U_{RS}'$, $U_{ST}'$, $U_{TR}'$) umgeformt wird.

4. Verfahren nach Anspruch 1, 2 oder 3, dadurch gekennzeichnet, dass alle drei Rechteckwellen ($I'_R$, $I'_S$, $I'_T$) der Ständerströme jeweils mit den zugehörenden Rechteckwellen ($U'_R$, $U'_S$, $U'_T$ bzw. $U'_{RS}$, $U'_{ST}$, $U'_{TR}$) der Ständerspannungen multipliziert werden, dass alle Multiplikationsergebnisse addiert werden und dass aus der Summe der Mittelwert ($\gamma$) gebildet wird.

5. Verfahren nach Anspruch 1, 2, 3 oder 4, dadurch gekennzeichnet, dass die Herausfilterung der Grundwellenanteile aus den Ständerspannungen ($U_R$, $U_S$, $U_T$) und die Drehung der Phase um 90° el. nacheilend jeweils in einem RC-Glied (R1, C1; R2, C2; R3 C3) durchgeführt wird.

6. Verfahren nach wenigstens einem der Ansprüche 1 bis 5, dadurch gekennzeichnet, dass der Mittelwert ($\gamma$) in einem Integrierglied (SV, CV) gebildet wird, dessen Integrationskonstante proportional zur Frequenz ($f_1$) der Ständerspannungen ($U_R$, $U_S$, $U_T$) bzw. Ständerströme ($I_R$, $I_S$, $I_T$) variiert.

7. Schaltungsanordnung zur Durchführung des Verfahrens nach den Ansprüchen 1, 2, 4, 5 oder 6, dadurch gekennzeichnet, dass am Ausgang eines Stromwandlers ein Nullspannungs-Komparator (KH1, KH2, KH3) mit Hysterese angeordnet ist, in dessen Eingangskreis ein Amplitudenbegrenzer (Di) liegt, dass am Ausgang wenigstens eines Spannungswandlers zwischen dem Mittelpunkt (Mp) und den Klemmen des Speisesystems der 3phasigen Asynchronmaschine ein Differenzverstärker (D1, D2, D3) angeordnet ist, dass der Ausgang des Differenzverstärkers (D1, D2,D3) über ein RC-Glied (R1C1, R2C2, R3C3) mit grosser Zeitkonstante an den Eingang eines Nullspannungs-Komparators ohne Hysterese (K1, K2, K3) geschaltet ist, dass die Ausgänge der beiden Komparatoren (KH1, K1; KH2, K2, KH3, K3) auf einen Multiplizierer (M1, M2, M3) geschaltet sind und dass der Ausgang des Multiplizierers auf einen Mittelwertbildner (SV, CV) geschaltet ist.

8. Schaltungsanordnung nach Anspruch 7, dadurch gekennzeichnet, dass die Anzahl der die Ströme ($I_R$,$I_S$,$I_T$) verarbeitenden Kreise und die Anzahl der Spannungen ($U_R$, $U_S$, $U_T$) verarbeitenden Kreise der Anzahl der Phasen der Asynchronmaschine entspricht und dass die Ausgänge der Multiplizierer (M1, M2, M3) auf einen Summierer (SV) geschaltet sind.

9. Schaltungsanordnung zur Durchführung des Verfahrens nach den Ansprüchen 1, 3, 4, 5 oder 6, dadurch gekennzeichnet, dass am Ausgang dreier Stromwandler je ein Nullspannungs-Komparator KH1, KH2, KH3) mit Hysterese angeordnet ist, in deren Eingangskreis ein Amplitudenbengrenzer (Di) liegt, dass am Ausgang dreier Spannungswandler zwischen je zwei Klemmen des Speisesystems der 3phasigen Asynchronmaschine je ein Differenzverstärker (D1, D2, D3) angeordnet ist, dass der Ausgang jedes Differenzverstärkers über je ein RC-Glied R1, C1; R2, C2; R3, C3) mit grosser Zeitkonstante sowohl an den ersten (Plus-)Eingang als auch zyklisch vertauscht an den zweiten (Minus-)Eingang je eines Komparators (K1, K2, K3) ohne Hysterese geschaltet ist, dass die Ausgänge beider Komparator-Arten (K1, KH1; K2, KH2; K3, KH3) auf je einen Multiplizierer (M1, M2, M3) geschaltet sind und dass die Ausgänge der Multiplizierer auf einen Summierer (SV) und dessen Ausgang auf einen Mittelwertbildner (SV, CV) geschaltet sind.

10. Schaltungsanordnung nach Anspruch 7, 8 oder 9, dadurch gekennzeichnet, dass der Komparator (KH1, KH2, KH3) mit Hysterese ein geschalteter Operationsverstärker ist.

11. Schaltungsanordnung nach wenigstens einem der Ansprüche 7 bis 10, dadurch gekennzeichnet, dass der Amplitudenbegrenzer im Eingangskreis des Komparators (KH1, KH2, KH3) mit Hysterese aus zwei antiparallelen Dioden (Di) besteht.

12. Schaltungsanordnung nach wenigstens einem der Ansprüche 7 bis 11, dadurch gekennzeichnet, dass der Differenzverstärker (D1, D2, D3) ein auf optimale Gleichtaktunterdrückung ausgelegter Operationsverstärker ist.

13. Schaltungsanordnung nach wenigstens einem der Ansprüche 7 bis 12, dadurch gekennzeichnet, dass dem RC-Glied (R1, C1; R2, C2; R3, C3) ein Umschalter (S1, S2, S3) vorgeschaltet ist, der bei Rechts- bzw. Linkslauf der Asynchronmaschine für die korrekte Zuordnung der Spannungs- und Stromphasen sorgt.

14. Schaltungsanordnung nach wenigstens einem der Ansprüche 7 bis 13, dadurch gekennzeichnet, dass der Komparator (K1, K2, K3) ohne Hysterese ein geschalteter Operationsverstärker ist.

15. Schaltungsanordnung nach wenigstens einem der Ansprüche 7 bis 14, dadurch gekennzeichnet, dass der Summierer am Ausgang des Multiplizierers (M1, M2, M3) und der Mittelwertbildner vereinigt und als geschalteter Operationsverstäker (SV, CV) ausgebildet sind.

16. Schaltungsanordnung nach Anspruch 15, dadurch gekennzeichnet, dass dem Summierer und Mittelwertbildner (SV, CV) ein Multiplizierer (M4) nachgeschaltet ist, an dessen zweitem Eingang ein Signal (F1) anliegt, das proportional der Frequenz ($f_1$) des die Asynchronmaschine speisenden Netzes ist, dessen Ausgang über einen Widerstand (RV) auf den Eingang des Summierers und Mittelwertbildners (SV, CV) zurückgeführt ist und an dessen Ausgang das dem Winkel ($\gamma$) entsprechende Signal abnehmbar ist.

17. Schaltungsanordnung nach Anspruch 16, dadurch gekennzeichnet, dass unmittelbar an den Ausgang des Multiplizierers (M4) ein als Pegelanpassungsglied geschalteter Operationsverstärker (V) geschaltet ist, an dessen Ausgang das dem Winkel ($\gamma$) entsprechende Signal abnehmbar ist.

**Claims**

1. A method for detecting the angle between the air-gap flux vector and the stator current vector of a three-phase asynchronous machine fed by a converter including an intermediate circuit, the stator voltages and the stator currents being measured in this method, characterised in that the current blocks of the stator currents ($I_R$, $I_S$, $I_T$) are converted into constant-amplitude square waves ($I'_R$, $I'_S$, $I'_T$) and are extended to 180° electrical, that the fundamental-wave components are filtered out of the stator voltages ($U_R$, $U_S$, $U_T$ or $U_{RS}$, $U_{ST}$, $U_{TR}$) that the phase of the fundamental-wave components is rotated by 90° electrical lagging, that the phase-rotated fundamental-wave components ($U_R''$, $U_S''$, $U_T''$ or $U_{RS}''$, $U_{ST}''$, $U_{TR}''$) are converted into constant-amplitudes square waves $U_R'$, $U_S'$, $U_T'$ or $U_{RS}'$, $U_{ST}'$, $U_{TR}'$), that at least one square wave ($I_R'$) of the currents is multiplied by the square wave ($U_S'$, $U_T'$, and $U_{RS}'$, $U_{TR}'$) of the voltage phase following the current phase and that from this the mean value ($\gamma$) is formed.

2. A method according to Claim 1, characterised in that the phase voltages ($U_R$, $U_S$, $U_T$) measured with respect to the centre point (Mp) of the system feeding the asynchronous machine (ASM) are evaluated as stator voltages.

3. A method according to Claim 1, characterised in that the interlinked votages ($U_{RS}$, $U_{ST}$, $U_{TR}$) of the system feeding the asynchronous machine (ASM) are evaluated as stator voltages, that the phase-rotated fundamental-wave components ($U_{RS}''$, $U_{TR}''$) of the interlinked voltages ($U_{RS}$, $U_{TR}$) similarly linked to the respective current phase ($I_R$) are substracted from each other and that the voltage difference is converted into a square wave ($U_{RS}'$, $U_{ST}'$, $U_{TR}'$).

4. A method according to Claim 1, 2 or 3, characterised in that all three square waves ($I_R'$, $I_S'$, $I_T'$) of the stator currents are in each case multiplied by the associated square waves ($U_R'$, $U_S'$, $U_T'$ and $U_{RS}'$, $U_{ST}'$, $U_{TR}'$) of the stator voltages, that all results of multiplications are added and that from the sum the mean value ($\gamma$) is formed.

5. A method according to Claim 1, 2, 3 or 4, characterised in that the filtering of the fundamental-wave components out of the stator voltages ($U_R$, $U_S$, $U_T$) and the rotating of the phase by 90° electrical lagging is in each case carried out in an RC section (R1, C1; R2, C2; R3, C3).

6. A method according to at least one of the Claims 1 to 5, characterised in that the mean value ($\gamma$) is formed in an integrating section (SV, CV) the integration constant of which varies in proportion to the frequency ($f_1$) of the stator voltages ($U_R$, $U_S$, $U_T$) or stator currents ($I_R$, $I_S$, $I_T$).

7. A circuit arrangement for carrying out the method according to Claims 1, 2, 4, 5 or 6, characterised in that at the output of current transformer, a zero-voltage comparator (KH1, KH2, KH3) with hysteresis is arranged in the input circuit of which an amplitude limiter (Di) is located, that at the output of at least one voltage transformer between the centre point (Mp) and the terminals of the supply system for the thre-phase asynchronous machine a differential amplifier (D1, D2, D3) is arranged, that the output of the differential amplifier (D1, D2, D3) is connected via an RC section (R1C1, R2C2, R3C3) with a large time constant to the input of a zero-voltage comparator without hysteresis (K1, K2, K3), that the outputs of the two comparators (KH1, K1; KH2, K2, KH3, K3) are connected to a multiplier (M1, M2, M3) and that the output of the multiplier is connected to a mean-value generator (SV, CV).

8. A circuit arrangement according to Claim 7, characterised in that the number of circuits which process the currents ($I_R$, $I_S$, $I_T$) and the number of circuits which process the voltages ($U_R$, $U_S$, $U_T$) corresponds to the number of phases of the asynchronous machine and that the outputs of the multipliers (M1, M2, M3) are connected to a summing stage (SV).

9. A circuit arrangement for carrying out the method according to Claims 1, 3, 4, 5 or 6, characterised in that at the output of three current transformers one each zero-voltage comparator (KH1, KH2, KH3) with hysteresis is arranged in the input circuit of which an amplitude limiter (Di) is located, that at the output of three voltage transformers one differential amplifier (D1, D2, D3) each is arranged between two terminals each of the supply system of the three-phase asynchronous machine, that the output of each differential amplifier is connected via one each RC section (R1, C1; R2, C2; R3, C3) having a large time constant to the first (positive) input and, cyclically interchanged, to the second (negative) input of one each comparator (K1, K2, K3) without hysteresis, that the outputs of the two types of comparator (K1, KH1; K2, KH2; K3, KH3) are connected to one each multiplier (M1, M2, M3) and that the outputs of the multipliers are connected to a summing stage (SV) and the output of this stage is connected to a mean-value generator (SV, CV).

10. A circuit arrangement according to Claim 7, 8 ou 9, characterised in that the comparator (KH1, KH2, KH3) with hysteresis is a switched operational amplifier.

11. A circuit arrangement according to at least one of Claims 7 to 10, characterised in that the amplitude limiter in the input circuit of the comparator (KH1, KH2, KH3) with hysteresis consists of two antiparallel diodes (Di).

12. A circuit arrangement according to at least one of Claims 7 to 11, characterised in that the differential amplifier (D1, D2, D3) is an operational amplifier which is designed for optimum common-mode rejection.

13. A circuit arrangement according to at least one of Claims 7 to 12, characterised in that the RC section (R1, C1; R2, C2; R3, C3) is preceded in the circuit by a change-over switch (S1, S2, S3) which provides for correct allocation of the voltage and current phases with clockwise or anticlockwise rotation of the asynchronous machine.

14. A circuit arrangement according to at least one of Claims 7 to 13, characterised in that the comparator (K1, K2, K3) without hysteresis is a switched operational amplifier.

15. A circuit arrangement according to at least one of Claims 7 to 14, characterised in that the summing stage at the output of the multiplier (M1, M2, M3) and the mean-value generator are combined and constructed as a switched operational amplifier (SV, CV).

16. A circuit arrangement according to Claim 15, characterised in that the summing stage and mean-value generator (SV, CV) are followed in the circuit by a multiplier (M4), at the second input of which a signal (F1) is present which is proportional to the frequency ($f_1$) of the system supplying the asynchronous machine, and the output of which is fed back via a resistance (RV) to the input of the summing stage and mean-value generator (SV, CV), and at the output of which the signal corresponding to the angle ($\gamma$) can be obtained.

17. A circuit arrangement according to Claim 16, characterised in that an operational amplifier (V) connected as a level-matching section is connected directly to the output of the multiplier (M4), at the output of which operational amplifier the signal corresponding to the angle (γ) can be obtained.

## Revendications

1. Procédé pour déterminer l'angle entre le vecteur de flux d'entrefer et le vecteur de courant de stator d'une machine asynchrone triphasée qui est alimentée par un mutateur ayant un circuit intermédiaire de courant, les tensions de stator et les courants de stator étant alors mesurés, caractérisé en ce que les blocs de courant des courants de stator ($I_R$, $I_S$, $I_T$) sont transformés en ondes carrées ($I'_R$, $I'_S$, $I'_T$) d'amplitude constante et sont prolongés électriquement à 180°, en ce qu'on filtre à partir des tensions de stator ($U_R$, $U_S$, $U_T$ ou $U_{RS}$, $U_{ST}$, $U_{TR}$) les proportions d'ondes fondamentales, en ce que la phase des proportions d'ondes fondamentales est tournée d'un retard électrique de phase de 90°, en ce que les proportions d'ondes fondamentales déphasées ($U''_R$, $U''_S$, $U''_T$ ou $U''_{RS}$, $U''_{ST}$, $U''_{TR}$) sont transformées en des ondes carrées ($U'_R$, $U'_S$, $U'_T$ ou $U'_{RS}$, $U'_{ST}$, $U'_{TR}$) d'amplitude constante, en ce qu'au moins une onde carrée ($I'_R$) des courants est multipliée par l'onde carrée ($U'_S$, $U'_T$, ou $U'_{RS}$, $U'_{TR}$) de la phase de tension suivant la phase de courant et en ce qu'on forme à partir d'elle la valeur moyenne (γ).

2. Procédé selon la revendication 1, caractérisé en ce que, en tant que tensions de stator, on exploite les tensions de phase ($U_R$, $U_S$, $U_T$) mesurées contre le point central (Mp) du réseau alimentant la machine asynchrone (ASM).

3. Procédé selon la revendication 1, caractérisé en ce qu'on exploite, comme tensions de stator, les tensions reliées ($U_{RS}$, $U_{ST}$, $U_{TR}$) du réseau alimentant la machine asynchrone (ASM), en ce que les proportions d'ondes fondamentales déphasées ($U''_{RS}$, $U''_{TR}$) des tensions reliées ($U_{RS}$, $U_{TR}$) enchaînées selon la même polarité avec la phase de courant respective ($I_R$) sont soustraites l'une de l'autre et en ce que la différence de tension est transformée en une onde carrée ($U'_{RS}$, $U'_{ST}$, $U'_{TR}$).

4. Procédé selon la revendication 1, 2 ou 3, caractérisé en ce que toutes les trois ondes carrées ($I'_R$, $I'_S$, $I'_T$) des courants de stator sont multipliées respectivement avec les ondes carrées associées ($U'_R$, $U'_S$, $U'_T$ ou $U'_{RS}$, $U'_{ST}$, $U'_{TR}$) des tensions de stator, en ce que tous les résultats de multiplication sont ajoutés et en ce qu'à partir de la somme on forme la valeur moyenne (γ).

5. Procédé selon la revendication 1, 2, 3 ou 4, caractérisé en ce que la filtration des proportions d'ondes fondamentales à partir des tensions de stator ($U_R$, $U_S$, $U_T$) et la rotation de la phase avec un retard électrique de 90° sont effectuées respectivement dans un élément RC (R1, C1; R2, C2; R3, C3).

6. Procédé selon au moins l'une des revendications 1 à 5, caractérisé en ce que la valeur moyenne (γ) est formée dans un élément d'intégration (SV, CV) dont la constante d'intégration varie proportionnellement à la fréquence ($f_1$) des tensions de stator ($U_R$, $U_S$, $U_T$) ou des courants de stator ($I_R$, $I_S$, $I_T$).

7. Disposition de circuit pour mettre en oeuvre le procédé selon les revendications 1, 2, 4, 5 ou 6, caractérisée en ce qu'à la sortie d'un transformateur de courant est disposé un comparateur de tension nulle (KH1, KH2, KH3) avec hystérésis dans le circuit d'entrée duquel se trouve un limiteur d'amplitude (Di), en ce qu'à la sortie d'au moins un transformateur de tension est disposé un amplicateur de différence (D1, D2, D3) entre le point central (Mp) et les bornes du système d'alimentation de la machine asynchrone triphasée, en ce que la sortie de l'amplificateur de différence (D1, D2, D3) est montée par l'intermédiaire d'un élément RC (R1C1, R2C2, R3C3) à constante de temps élevée à la sortie d'un comparateur de tension nulle sans hystérésis (K1, K2, K3), en ce que les sorties des deux comparateurs (KH1, K1; KH2, K2, KH3, K3) sont montées sur un multiplicateur (M1, M2, M3) et en ce que la sortie du multiplicateur est montée sur un formateur de valeur moyenne (SV, CV).

8. Disposition de circuit selon la revendication 7, caractérisée en ce que le nombre des circuits traitant les courants ($I_R$, $I_S$, $I_T$) et le nombre des circuits traitant les tensions ($U_R$, $U_S$, $U_T$) correspond au nombre des phases de la machine asynchrone et en ce que les sorties des multiplicateurs (M1, M2, M3) sont appliquées à un dispositif d'addition (SV).

9. Disposition de circuit pour mettre en oeuvre le procédé selon les revendications 1, 3, 4, 5 ou 6, caractérisée en ce qu'à la sortie des trois transformateurs de courant, on dispose respectivement un comparateur de tension nulle (KH1, KH2, KH3) avec hystérésis dans le circuit d'entrée desquels se trouve un limiteur d'amplitude (Di), en ce qu'à la sortie des trois transformateurs de tension on dispose entre deux bornes respectives du système d'alimentation de la machine asynchrone triphasée un amplificateur de différence respectif (D1, D2, D3), en ce qu'à la sortie de chaque amplificateur de différence, on monte un comparateur respectif (K1, K2, K3) sans hystérésis par l'intermédiaire d'un élément RC respectif (R1, C1; R2, C2; R3, C3) à grande constante de temps à la fois sur la première entrée plus et sur la deuxième entrée moins de façon alternée cycliquement, en ce que les sorties des deux types de comparateurs (K1, KH1; K2, KH2; K3, KH3) sont montées sur un multiplicateur respectif (M1, M2, M3) et en ce que les sorties des multiplicateurs sont montées sur un dispositif d'addition (SV) et sa sortie sur un formateur de valeur moyenne (SV, CV).

10. Disposition de circuit selon la revendication 7, 8 ou 9, caractérisée en ce que le comparateur (KH1, KH2, KH3) avec hystérésis est un amplificateur d'opération commuté.

11. Disposition de circuit selon au moins l'une des revendications 7 à 10, caractérisée en ce que le limiteur d'amplitude se trouvant dans le circuit d'entrée du comparateur (KH1, KH2, KH3) avec hystérésis est constitué par deux diodes anti-parallèles (Di).

12. Disposition de circuit selon au moins l'une des revendications 7 à 11, caractérisée en ce que l'amplificateur de différence (D1, D2, D3) est un amplificateur opérationnel prévu pour une réjection optimale en coïncidence de phases.

13. Disposition de circuit selon au moins l'une des revendications 7 à 12, caractérisée en ce qu'on monte en amont de l'élément RC (R1, C1; R2, C2; R3, C3) un inverseur (S1, S2, S3) qui, lors de la marche vers la droite ou vers la gauche de la machine asynchrone, assure l'association correcte des phases de tension et de courant.

14. Disposition de circuit selon au moins l'une des revendications 7 à 13, caractérisée en ce que le comparateur (K1, K2, K3) sans hystérésis est un amplificateur d'opération commuté.

15. Disposition de circuit selon au moins l'une des revendications 7 à 14, caractérisée en ce que le dispositif d'addition à la sortie du multiplicateur (M1, M2, M3) et le formateur de valeur moyenne sont réunis et sont conformés comme un amplificateur d'opération (SV, CV) commuté.

16. Disposition de circuit selon la revendication 15, caractérisée en ce qu'on monte en aval du dispositif d'addition et du formateur de valeur moyenne (SV, CV) un multiplicateur (M4) sur la deuxième entrée duquel on applique un signal (F1) qui est proportionnel à la fréquence $(f_1)$ du réseau alimentant la machine asynchrone et dont la sortie est renvoyée par l'intermédiaire d'une résistance (RV) à l'entrée du dispositif d'addition et du formateur de valeur moyenne (SV, CV), tandis qu'on peut prélever à sa sortie le signal correspondant à l'angle $(\gamma)$.

17. Disposition de circuit selon la revendication 16, caractérisée en ce que directement à la sortie du multiplicateur (M4) on monte en tant qu'élément d'adaptation du niveau un amplificateur d'opération (V) commuté sur la sortie duquel on peut prélever le signal correspondant à l'angle $(\gamma)$.

Fig. 1

Fig. 2

Fig. 3

Fig. 4

Fig. 5

Fig. 6

0 061 603

Fig. 7

0 061 603